# EUROPEAN PATENT SPECIFICATION

(11) **EP 0 587 442 B1**
(45) Date of publication and mention of the grant of the patent: **17.02.1999**
(21) Application number: 93307165.6
(22) Date of filing: 10.09.1993
(51) Int. Cl.: H01L 21/60, H01L 23/485

(54) **Method of wire bonding over the active circuit area of an integrated circuit device**
Verfahren zum Drahtbonden über einem aktiven Gebiet eines integrierten Bauelements
Procédé de soudage d'un fis au dessus d'une région active d'un dispositif à circuit intégré

(30) Priority: 10.09.1992 US 943087
(43) Date of publication of application: 16.03.1994
(73) Proprietor: TEXAS INSTRUMENTS INCORPORATED, Dallas Texas 75265 (US)
(72) Inventor: Heinen, Katherine G., Dallas, Texas 75230 (US); Alfaro,Rafael Verity Instruments Inc., Carrollton Texas 75006 (US); Stierman, Roger J., Dallas, Texas 75248 (US)
(74) Representative: Blanco White, Henry Nicholas

(56) References cited:
- DE-A- 4 201 792
- GB-A- 2 184 600
- US-A- 4 017 886
- US-A- 5 201 454
- SOLID STATE TECHNOLOGY, vol.34, no.12, December 1991, WASHINGTON US pages 37 - 38 T. H. RAMSEY ET AL
- ELECTRONIC PACKAGING AND PRODUCTION, vol.32, no.2, February 1992, MASSACHUSETTS US pages 72 - 76 G. M. ADEMA ET AL
- PATENT ABSTRACTS OF JAPAN vol. 13, no. 401 (E-816) 6 September 1989 & JP-A-01 143 333 (CHIYOUONPA KOGYO K. K.) 5 June 1989

## Description

### FIELD OF THE INVENTION

This invention relates generally to a method of wire bonding on an integrated circuit device and, more particularly, to wire bonding with bonding pads arranged over the active circuit area of the device.

### BACKGROUND OF THE INVENTION

Conventional integrated circuit chips have bonding pads arranged peripherally outside of the active circuit area of the chip. The bonding pads must be large enough to accommodate either ball bonding or stitch bonding connections. The chip must be large enough to accommodate the active circuit area plus the additional area occupied by the bonding pads. Thus, bonding pads disadvantageously increase the size of the chip.

Another problem with peripherally arranged bonding pads is that additional bus structure may be necessary to connect the bonding pads to the terminations of the active circuit. Such additional bus structure disadvantageously increases the cost and complexity of the chip, and may deteriorate the speed of the chip due to increased interconnection length.

In view of the foregoing disadvantages associated with peripheral bonding pads, attempts have previously been made to fabricate integrated circuit chips with the bonding pads arranged directly over the active circuit area This would reduce the size, cost and complexity of the chip. However, these previous attempts have encountered difficulties. For example, stray capacitances can develop between the bonding pads and the active circuit. Also, the relatively brittle protective overcoat layer which covers the active circuit can be damaged by the impact and shearing forces associated with the wire bonding and plastic packaging process. In some cases these forces crack the overcoat layer. In other cases the damage to the overcoat layer, although not severe enough to actually cause cracking, weakens the overcoat layer to the extent that the conventional plastic overmolding process and variations in thermal expansion associated with temperature cycling subsequently cause cracking in the overcoat layer.

It is therefore desirable to provide an integrated circuit chip which has bonding pads arranged over the active circuit area and which avoids problems such as those mentioned above.

US-A 4 017 886 discloses a discrete semiconductor device having an insulating cover layer of SiO₂ on which a polymer resin layer, which may be a polyimide layer 5 to 8 µm thick, is formed between the semiconductor device and the bonding pads.

GB-A 2 184 600 discloses providing a bonding pad on a semiconductor device with protective layers, one of which is formed from a polyimide material, between the bonding pad and the underlying active region of the device. A metal conductor passes through the protective layers to provide an electrical connection to the bonding pad.

DE-A 42 01 792 discloses a semiconductor device with an insulating layer below the bonding pads, a protective insulating layer, which may be of SiO₂ or Si₃N₄, above the bonding pads, and an elastic layer on top of the protective insulating layer, the device as a whole being encapsulated.

Solid State Technology 34(1991) No. 12, pp 37-38, discloses bonding wire bonds to bonding pads using ultrasonic energy at 100 kHz. There is no indication of how the bonding pads were mounted during the experiments.

US-A-5 201 454 (which was published after the priority date of the present application) discloses the use of ultrasonic energy at a frequency of about 100-125 MHz to bond a wire to a bond pad on an IC device.

Electronic Packaging and Production 32 (1992) No. 2, pp 72-76, lists various polyimide materials considered suitable as a thin-film insulating layer in multilayer interconnections between chips in a multichip module.

The invention as claimed in claims 1 & 6 provides a method of effecting wire bonding over an active circuit of an integrated circuit device (10), comprising the steps of: providing a layer of a polyimide materials in overlying relationship relative to the active circuit; the polyimide layer having a modulus of elasticity in a range of approximately 6-13 GPa and a coefficient of thermal expansion in a range of approximately 3 x 10⁻⁶ to 10 x 10⁻⁶ /°K; depositing a bonding pad on the polyimide layer opposite the active circuit; connecting the bonding pad electrically to the active circuit through the polyimide layer, and bonding a wire to the bonding pad using a bonding transducer at a frequency of at least 100 kHz.

Exemplary embodiments of the present invention are described below with reference to the appended drawings, in which:
Figure 1 is a fragmentary cross-sectional view of an integrated circuit device made by a method according to the present invention;
Figure 2 is a fragmentary cross-sectional view showing an alternative arrangement of the bond pad of Figure 1;
Figure 3 is an elevational view of a bonding transducer which is part of a bonding apparatus used to make the wire bonds of Figures 1 and 2; and
Figure 4 is a diagrammatic view of the bonding apparatus used to make the wire bonds of Figures 1 and 2.

### DETAILED DESCRIPTION

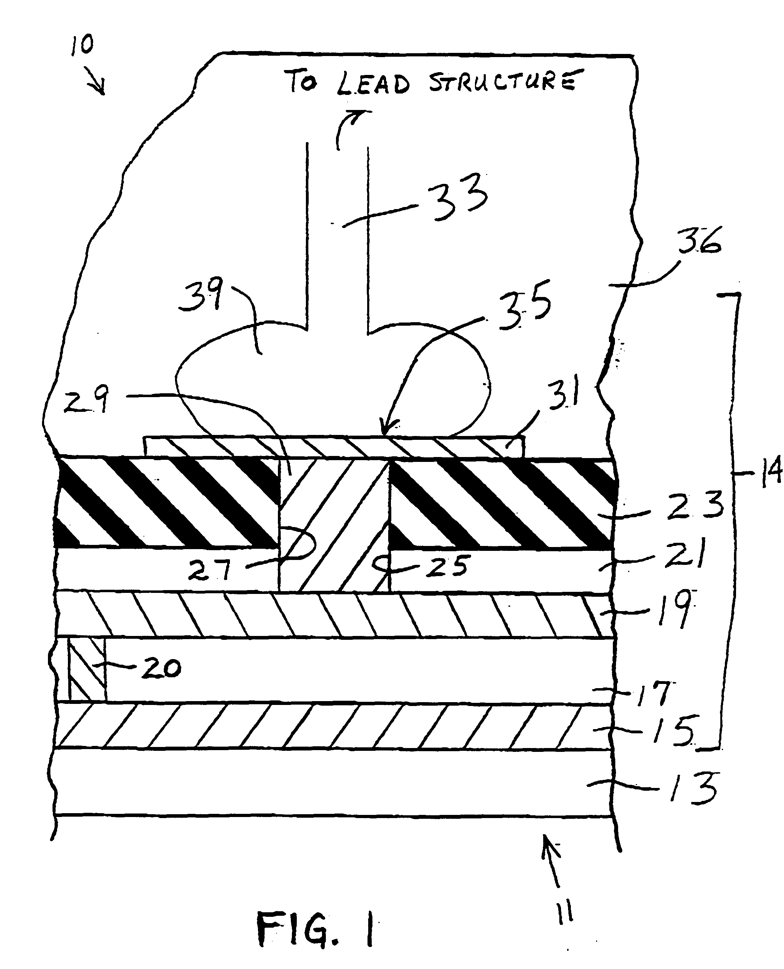

An exemplary embodiment of an integrated circuit made by the method of the present invention is shown in Figure 1. The integrated circuit device 10 includes an electrical circuit 11. A connecting arrangement 14 is provided for electrically connecting the electrical circuit 11 to an external lead structure. Figure 1 illustrates a single connecting arrangement 14, but it will be understood that the integrated circuit device 10 includes a plurality of such connecting arrangements 14 to accommodate the electrical circuit 11. The electrical circuit 11 has an active circuit area 13 which includes functional circuit elements that are connected to the lead structure by connecting arrangement 14.

Connecting arrangement 14 includes electrically conductive metal layers 15 and 19 overlying the active circuit area 13 to provide electrical access to the functional circuit elements of active circuit area 13. In Figure 1, a lower metal layer 15 and an upper metal layer 19 are arranged in overlying relationship relative to the active circuit area 13. The lower metal layer 15 is electrically connected to a desired circuit node of the active circuit area 13. An inter-level oxide layer 17 is interposed between the upper and lower metal layers 19 and 15. The upper metal layer 19 is connected to the lower metal layer 15 by a conductor 20 which extends through layer 17. Thus the upper metal layer 19 makes electrical contact with the lower metal layer 15.

A protective overcoat 21 is provided over the upper metal layer 19 in overlying relationship relative to the electrical circuit 11. The overcoat 21 may be, for example, a 1 µm layer of silicon nitride or silicon oxide. The overcoat layer 21 has a plurality of contact openings 25 provided therein, one of which is shown in Figure 1.

A layer of polyimide material 23 is provided over the overcoat 21 in overlying relationship relative to the electrical circuit 11. Those skilled in the art will be familiar with polyimide materials in general, because such materials have been used as protective overcoats and conformal insulating layers in prior art integrated circuit devices. The polyimide layer 23 may be, for example, of the type BPDA-PDA (bisphenyldianhydride-phenyldiamine) The polyimide layer 23 has a plurality of contact openings 27 provided therein, one of which is shown in Figure 1. The polyimide layer 23 should preferably have the following exemplary parameters: a thickness of 3-6 micrometres; a relatively high modulus of elasticity, for example, approximately 6-13 GPa; a relatively low coefficient of thermal expansion, for example, in a range of approximately 3-10 x 10⁻⁶/°K; and a low dielectric constant, for example, approximately 3.0. An example of a commercially available polyimide which is suitable for practicing the invention is DuPont 2611 Polyimide.

Each contact opening 25 of the overcoat layer 21 is aligned with a corresponding contact opening 27 of the polyimide layer 23, as illustrated in Figure 1. These aligned openings 25 and 27 are preferably not aligned with the conductor 20 which connects metal layers 15 and 19. Metal conductors 29 are provided in the aligned openings 25 and 27, one such conductor being shown in Figure 1. A plurality of bonding sites are provided on top of the polyimide layer 23. The bonding sites may be, for example, conventional aluminum bonding pads 31, one such bonding pad being shown in Figure 1. The bonding pad 31 must be electrically conductive, and various metal alloys can be used, for example, an aluminum alloy with 2% copper.

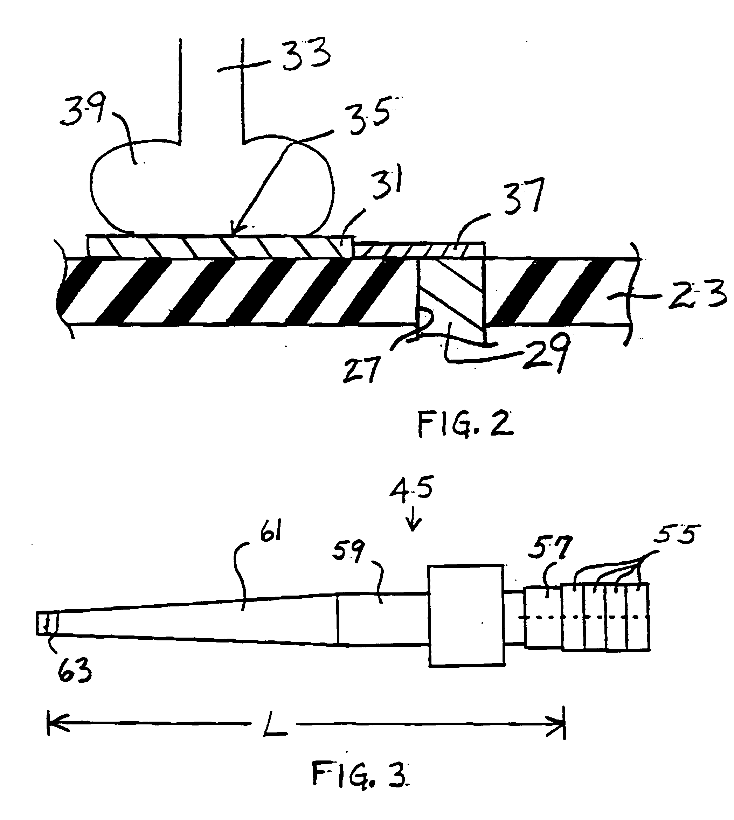

The conductor 29 electrically contacts the bonding pad 31 either directly, as shown in Figure 1, or through a suitable metal conductor 37 deposited on top of the polyimide layer 23, as shown in Figure 2. The conductor 29 extends from the upper surface of the polyimide layer 23 toward the electrical circuit 11, and terminates in electrical contact with the upper metal layer 19.

The integrated circuit device 10 also includes a plurality of electrically conductive wires 33, one of which is shown in Figure 1. The wire 33 may be pure gold, a gold alloy, or some other metal or metal alloy. The wire 33 connects the bonding pad 31 to a lead structure. The wire 33 is bonded to the bonding pad 31 by a wire bond 35. The wire 33 has an enlarged bond end 39 which facilitates making the wire bond 35 to the bonding pad 31.

The aforementioned structure of Figure 1 is encapsulated by a conventional resin molding compound 36 such as plastic.

The polyimide layer 23 absorbs and controls the stresses transmitted to the overcoat 21 during wire bonding. The polyimide layer 23 is sufficiently rigid to permit successful wire bonding, and is also sufficiently elastic to avoid cracking or otherwise damaging the overcoat 21 or the polyimide layer itself during the wire bonding operation. Thus, subsequent plastic overmolding and temperature cycling will not result in cracking of the overcoat 21 or the polyimide layer 23. The polyimide layer 23 has a relatively low dielectric constant and a relatively large thickness, and this combination limits capacitive interaction between the bonding pads 31 and the underlying electrical circuit 11.

The wire bonding operation is significantly less likely to damage the overcoat 21 if high frequency bonding is used. A suitable high frequency wire bonding operation can be accomplished as described below.

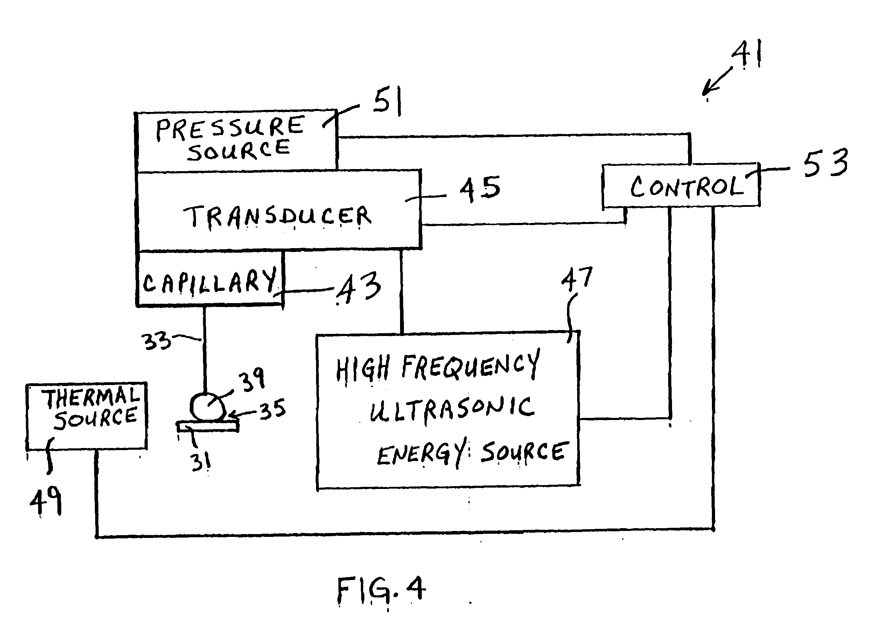

A bonding apparatus 41 used to make the wire bonds 35 is illustrated diagrammatically in Figure 4. The bonding apparatus 41 utilizes high frequency (100 kHz and above) ultrasonic energy. The apparatus 41 includes a capillary 43, a transducer 45, a high frequency ultrasonic energy source 47, a thermal source 49, a pressure source 51, and a control section 53.

The capillary 43 acts as a conduit for the wire 33 and, during the bonding process, imparts pressure and ultrasonic energy at the wire bond 35. The structure and operation of the capillary 43 is well known in the art.

Referring to Figure 3, the transducer (or horn) 45 is about ten centimeters long and includes four piezoelectric crystals 55 on the tail end 57 thereof. The transducer 45 also includes a body portion 59 and a tapered front end portion 61 having a tool clamp point 63 where the capillary 43 is mounted. The effective length L of the transducer 45 should be set so that the tool clamp point 63 is at the optimum position for imparting high frequency ultrasonic energy.

Once the ultrasonic bonding frequency has been selected, the transducer 45 can be designed to have an effective length L, equal to, for example, 2.25 wavelengths of the ultrasonic energy. Thus, the effective length L of the transducer 45 depends upon the selected frequency. Referring again to Figure 4, the energy source 47 is designed to provide an AC signal at the desired frequency. The energy source 47 is connected to the piezoelectric crystals 55 of Figure 3 in a conventional manner so that the AC signal is applied to the crystals. The ultrasonic frequency at the wire bond interface between the bond end 39 and the bond pad 31 may differ slightly from the frequency of the AC signal provided by energy source 47, as is well known in the art.

The thermal source 49 is conventional and provides thermal energy at the wire bond 35 to facilitate the bonding process. The pressure source 51 is conventional and provides pressure (mashing) to the wire bond 35 via the capillary 43.

The wire bonding operation begins by heating the wire 33 to form the bond end 39 as is well known in the art. The bond end 39 is then brought into contact with the bonding pad 31 so as to present between the bond end 39 and the bonding pad 31 an interface where the bonding will occur. The thermal source 49 applies heat as required, while the capillary 43 positions and secures the bond end 39 at the bonding pad 31, the transducer 45 provides the high frequency ultrasonic energy, and the pressure source 51 applies mashing force via the capillary 43. It will be apparent to those skilled in the art that all of the steps of the bonding operation can be suitably controlled by the control section 53.

At a frequency of approximately 114 kHz, for example, acceptable bonding can be achieved at temperatures from approximately 175°C through approximately 280°C and beyond, with a bonding time of approximately 5 ms. Higher frequencies permit bonding at lower temperatures. For example, a 350 kHz frequency has produced acceptable bonds at 27°C. Lower bonding temperatures will help limit the thermal expansion of the polyimide layer 23 during bonding.

The high frequency oparation described above requires a reduction in the number of piezoelectric forming the motor of the bonding transducer. Thus, the transducer 45 of Figure 3 has fewer piezoelectric crystals 55 than conventional transducers which operate at lower frequencies. Due to this reduction in the number of crystals, a higher power output is required to achieve optimum bonds. More specifically, ultrasonic power is generally in the range of 80-250 mW for most low frequency (below 100 kHz) transducers, while the high frequency (100 kHz and above) transducer 45 has a typical range of 150-300 mW.

An important factor which affects the high frequency ultrasonic power output is the impedance of transducer 45. For example, at frequencies above 100 kHz, transducer 45 can be operated at 18 ohms (+/- 5 ohms) impedance when installed in a bondhead assembly.

The above-described high frequency, low temperature wire bonding operation may be achieved, for example, by modifying a conventional Abacus III bonder as necessary to carry out the type of operation described above. The Abacus III bonder is manufactured by Texas Instruments Incorporated of Dallas, Texas. Further discussion of high frequency ultrasonic bonding can be found in the aforementioned copending applications incorporated by reference.

As an alternative to the Figure 1 structure, it has also been found that acceptable bonding over the active circuit 13 can be accomplished in the same general manner described above but omitting the overcoat 21 from the integrated circuit device 10. In this alternative embodiment the polyimide layer 23 is provided directly on top of the upper metal layer 19.

## Claims

1. A method of effecting wire bonding over an active circuit (11, 13) of an integrated circuit device (10), comprising the steps of: providing a layer of a polyimide material (23) in overlying relationship relative to the active circuit (11); the polyimide layer having a modulus of elasticity in a range of approximately 6-13 GPa and a coefficient of thermal expansion in a range of approximately 3 x 10⁻⁶ to 10 x 10⁻⁶ /°K; depositing a bonding pad (31) on the polyimide layer opposite the active circuit (11); connecting the bonding pad (31) electrically to the active circuit (11) through the polyimide layer (23), and bonding (35) a wire (33) to the bonding pad using a bonding transducer (45) at a frequency of at least 100 kHz.

2. A method according to claim 1, comprising providing the polyimide layer having a thickness in a range of approximately 3 to 6 micrometres and having a dielectric constant of approximately 3.

3. A method according to Claim 1 or claim 2, wherein said connecting step includes the steps of providing in the polyimide layer a through opening (27) which extends through the polyimide layer, and placing in the opening an electrical conductor (29) which extends through the opening and terminates in electrical contact with the active circuit (11).

4. A method according to any of claims 1 to 3, comprising providing the wire (33) made from gold.

5. A method according to any of claims 1 to 4, comprising molding an encapsulant (36) onto the polyimide layer (23), the bonding pads (31), and the wires (33).

6. The use, for effecting wire bonding over an active circuit (11, 13) of an integrated circuit device comprising: a layer of polyimide material (23) disposed in overlying relationship relative to said active circuit (11); wherein the polyimide layer (23) has a modulus of elasticity in a range of approximately 6-13 GPa and a coefficient of thermal expansion in a range of approximately 3 x 10⁻⁶ to 10 x 10⁻⁶ /°K; a plurality of bonding pads (31) deposited on said polyimide layer (23), said polyimide layer being interposed between said active circuit (11) and said bonding pads (31), said bonding pads being electrically connected to said active circuit through said polyimide layer, and a plurality of wires (33) for connecting said bonding pads (31) to a lead structure, each said wire (33) having an enlarged bond end (39) which is bonded to a respective said bonding pad (31) by a bond obtained using a bonding transducer (45) at a frequency of at least 100kHz.

## Patentansprüche

1. Verfahren zum Drahtbonden über einer aktiven Schaltung (11, 13) einer integrierten Schaltungsvorrichtung (10), bei dem eine Schicht (23) aus Polyimidmaterial über der aktiven Schaltung (11) vorgesehen wird; wobei die Polimidschicht einen Elastizitätsmodul in einem Bereich von ungefähr 6-13 GPa und einen thermischen Ausdehnungskoeffizienten in einem Bereich von ungefähr 3 x 10⁻⁶ bis 10 x 10⁻⁶ /K aufweist; ein Bondkontaktflecken (31) auf der der aktiven Schaltung (11) gegenüberliegenden Seite der Polimidschicht abgeschieden wird; der Bondkontaktflecken (31) durch die Polimidschicht (23) elektrisch mit der aktiven Schaltung (11) verbunden wird; und ein Draht (33) an den Bondkontaktflecken unter Verwendung eines Bondwandlers (45) mit einer Frequenz von wenigstens 100 kHz gebondet (35) wird.

2. Verfahren nach Anspruch 1, bei dem eine Polimidschicht mit einer Dicke in einem Bereich von ungefähr 3 bis 6 Mikrometern und mit einer Dielektrizitätskonstanten von ungefähr 3 vorgesehen wird.

3. Verfahren nach Anspruch 1 oder Anspruch 2, bei dem bei dem Verbinden in der Polimidschicht eine Durchgangsöffnung (27) vorgesehen wird, die sich durch die Polimidschicht erstreckt, und in die Öffnung ein elektrischer Leiter (29) gesetzt wird, der sich durch die Öffnung erstreckt und in einem elektrischen Kontakt mit der aktiven Schaltung (11) endet.

4. Verfahren nach einem der Ansprüche 1 bis 3, bei dem ein Draht (33) aus Gold vorgesehen wird.

5. Verfahren nach einem der Ansprüche 1 bis 4, bei dem eine Vergußkapselung (36) auf die Polimidschicht (23), die Bondkontaktflecken (31) und die Drähte (33) gegossen wird.

6. Anwendung für das Drahtbonden über einer aktiven Schaltung (11, 13) einer integrierten Schaltungsvorrichtung (10), mit einer Schicht (23) aus Polimidmaterial, die über der aktiven Schaltung (11) angeordnet ist; wobei die Polimidschicht einen Elastizitätsmodul in einem Bereich von ungefähr 6-13 Gpa und einen thermischen Ausdehnungskoeffizienten in einem Bereich von ungefähr 3 x 10⁻⁶ bis 10 x 10⁻⁶ /K aufweist; mehreren Bondkontaktflecken (31), die auf der Polimidschicht (23) angeordnet sind, wobei die Polimidschicht zwischen der aktiven Schaltung (11) und den Bondkontaktflecken (31) liegt und die Bondkontaktflecken durch die Polimidschicht mit der aktiven Schaltung elektrisch verbunden sind, und mehreren Drähten (33), die die Bondkontaktflecken (31) mit einer Anschlußleitungsstruktur verbinden, wobei jeder Draht (33) ein verdicktes Verbindungsende (39) aufweist, das über eine Bondverbindung, die unter Verwendung eines Bondwandlers (45) mit einer Frequenz von wenigstens 100 kHz erzielt wird, mit einem entsprechenden Bondkontaktflecken (31) verbunden ist.

## Revendications

1. Procédé d'exécution d'un soudage de fils sur un circuit actif (11, 13) d'un dispositif (10) à circuit intégré, comprenant les étapes suivantes : disposition d'une couche de matière polyimide (23) en recouvrement sur le circuit actif (11): la couche de polyimide ayant un module d'élasticité situé dans une plage d'approximativement 6 - 13 GPa et un coefficient de dilatation thermique situé dans une plage d'approximativement 3 x 10⁻⁶ à 10 x 10⁻⁶/°K, dépôt d'une plage de connexion (31) sur la couche de polyimide opposée au circuit actif (11) ; connexion électrique de la plage de connexion (31) au circuit actif (11) par l'intermédiaire de la couche de polyimide (23), et soudage (35) d'un fil (33) à la plage de connexion en utilisant un transducteur de soudage (45) à une fréquence d'au moins 100 kHz.

2. Procédé selon la revendication 1, comprenant l'utilisation d'une couche de polyimide ayant une épaisseur située dans une plage d'approximativement 3 à 6 micromètres et ayant une constante diélectrique d'approximativement 3.

3. Procédé selon la revendication 1 ou la revendication 2, dans lequel ladite étape de soudage comporte les étapes de formation, dans la couche de polyimide, d'une ouverture traversante (27) qui traverse la couche de polyimide, et de disposition dans l'ouverture d'un conducteur électrique (29) qui traverse l'ouverture et se termine en contact électrique avec le circuit actif (11).

4. Procédé selon l'une quelconque des revendications 1 à 3, comprenant l'utilisation d'un fil (33) réalisé en or.

5. Procédé selon l'une quelconque des revendications 1 à 4, comprenant le moulage d'un agent d'enrobage (36) sur la couche de polyimide (23), les plages de connexion (31) et les fils (33).

6. Utilisation, pour exécuter un soudage de fils sur un circuit actif (11, 13) d'un dispositif à circuit intégré comprenant : une couche de matière polyimide (23) disposée en recouvrement sur ledit circuit actif (11) ; la couche de polyimide (23) ayant un module d'élasticité situé dans une plage d'approximativement 6 - 13 GPa et un coefficient de dilatation thermique situé dans une plage d'approximativement 3 x 10⁻⁶ à 10 x 10⁻⁶ /°K; une pluralité de plages de connexion (31) déposées sur ladite couche de polyimide (23), ladite couche de polyimide étant interposée entre ledit circuit actif (11) et lesdites plages de connexion (31) lesdites plages de connexion étant connectées électriquement audit circuit actif par l'intermédiaire de ladite couche de polyimide, et une pluralité de fils (33) pour connecter lesdites plages de connexion (31) à une structure de conducteurs, chacun desdits fils (33) ayant une extrémité de connexion (39) agrandie qui est soudée à une plage respective desdites plages de connexion (31) par une soudure obtenue en utilisant un transducteur (45) de soudage à une fréquence d'au moins 100 kHz.
